# EUROPÄISCHE PATENTSCHRIFT

(11) **EP 0 991 337 B1**
(45) Veröffentlichungstag und Bekanntmachung des Hinweises auf die Patenterteilung: **07.04.2004**
(21) Anmeldenummer: 99922112.0
(22) Anmeldetag: 20.04.1999
(51) Int. Cl.: A44C 17/00, G04B 19/12

(54) **SCHMUCKSTEINE**
ORNAMENTAL STONES
PIERRES ORNEMENTALES

(30) Priorität: 23.04.1998 DE 29807331 U; 23.09.1998 DE 29817072 U; 01.10.1998 DE 29817487 U; 12.11.1998 DE 29820230 U
(43) Veröffentlichungstag der Anmeldung: 12.04.2000
(73) Patentinhaber: Winter CVD Technik GmbH, 22609 Hamburg (DE)
(72) Erfinder: WINTER, Ernst, Michael, D-22609 Hamburg (DE); SCHÄFER, Lothar, D-38527 Abbesbüttel (DE); MATTHEE, Thorsten, D-38527 Meine (DE)
(74) Vertreter: Liebelt, Rolf, Dipl.-Ing.
(86) Internationale Anmeldenummer: PCT/EP1999/002654
(87) Internationale Veröffentlichungsnummer: WO 1999/055188

(56) Entgegenhaltungen:
- EP-A- 0 399 072
- WO-A-93/17593
- DE-U- 9 207 571
- FR-A- 2 285 100
- GB-A- 2 083 842
- US-A- 4 490 440

## Beschreibung

Die Erfindung betrifft Schmucksteine für Schmuckstücke.

Schmucksteine, insbesondere Edelsteine, werden, bevor sie im Metallkörper eines Schmuckstückes gefaßt werden, geschliffen oder angeschliffen, um das einfallende Licht zu reflektieren, wodurch der Glanz eines Schmucksteines bewirkt wird. Dies setzt jedoch eine Mindestgröße und Reinheit des Schmucksteines voraus. So eignen sich etwa zwei Drittel der geschürften Diamanten nicht zur Herstellung von Schmucksteinen durch Schleifen, weil sie entweder zu geringe Körperlichkeit bzw. Tiefe haben oder sich wegen ihrer Farbe oder ihrer Einschlüsse nur industriell (für technische Zwecke) verwerten lassen.

Künstliche nach dem CVD-Verfahren hergestellte Diamantschichten sind entweder zu teuer oder zu dünn, um daraus geschliffene Schmucksteine, z. B. Brillanten, herzustellen.

In der US-A-4 490 440 wird ein Schmuckstein beschrieben, dessen Körper aus einem Halbleitersubstrat, insbesondere einem Siliciumwafer besteht. Auf mindestens einer Fläche des etwa 0,5 mm dicken Wafers ist eine Licht reflektierende Schicht niedergeschlagen. Die Schicht ist derart strukturiert, daß es zu Beugungserscheinungen des auftreffenden Lichtes kommt. Die Beugungserscheinungen, die auch farbig sein können, werden mit Gittern erreicht, deren Abmessungen in der US-A-4 490 440 festgelegt sind.

Aus der DE-U-92 07 571.1 ist ein Schmuckstück bekannt, das mindestens einen polykristallinen Diamanten mit einer geschliffenen Oberfläche aufweist, in der Vertiefungen mit einer Tiefe von etwa 15 bis 30 p ausgebildet sind. Diese Vertiefungen sind mit einer von der schwarzen Oberfläche des Diamanten farblich abweichenden Beschichtung versehen.

Die FR-A-2 285 100 beschreibt ein Schmuckstück mit einem Hartmetallgrundkörper, auf dem eine oder mehrere übereinander liegende Hartstoffdeckschichten mit das gesamte Farbspektrum umfassenden Eigenschaften aufgetragen sind.

Aufgabe der Erfindung ist es nun, auch jenen natürlichen und künstlichen Schmucksteinen, insbesondere Diamanten, die nur für technische bzw. industrielle Zwecke verwendet werden können, Eignung für den Schmuckbereich zu verleihen.

Diese Aufgabe wird erfindungsgemäß mit einem Schmuckstein gelöst, dessen Körper aus einem nur für technische oder industrielle Zwecke geeigneten natürlichen oder künstlichen Stein mit mindestens einer vorzugsweise glatten Sichtfläche als Träger einer strukturierten und vorzugsweise glänzenden Materialschicht, vorzugsweise einer Edelmetalloder Titannitridschicht versehen ist. Die Sichtfläche kann von der naturgegebenen Oberfläche eines Minerales, so wie es erdgeschichtlich oder in der Synthese (CVD, PKD) auskristallisiert ist, gebildet werden.

Die nach der Erfindung zweckmäßigerweise mit einem lithographischen Verfahren strukturierte Materialschicht verleiht dem Schmuckstein, dessen Körper z. B. ein Naturstein, wie ein vollständiger Rohdiamant, eine mit der Lasertechnik von einem Naturstein abgetrennte Steinscheibe, eine nach der CVD-Technik auf einem Substrat, vorzugsweise Silicium abgeschiedene Diamantschicht oder ein polykristallines Diamantaggregat (PKD) sein kann, nicht nur ein attraktives Aussehen. Die Strukturierung der auf mindestens einer ebenen, konkaven und/oder konvexen sowie vorzugsweise glatten Fläche aufgebrachten Materialschicht kann auch den Wünschen des Erwerbers des mit einem erfindungsgemäß gestalteten Schmuckstein versehenen Schmuckstückes angepaßt werden, indem z. B. ein Portrait, ein Sternzeichen, Ornament oder dgl. durch die Strukturierung dargestellt wird. Auf die Materialschicht kann noch eine durchsichtige Schutzschicht, vorzugsweise mit der CVD-Technik, aufgebracht sein, um Beschädigungen der Strukturierung zu verhindern.

Besondere Vorteile bei der Herstellung der erfindungsgemäßen Schmucksteine bietet die CVD-Diamantsynthese. Mit dieser Synthese können Diamantflächen geschaffen werden, die weder in der Natur anzutreffen sind noch mit anderen Syntheseverfahren erhalten werden. Während Naturdiamanten mit Sichtflächen von 100 mm² eine Rarität sind, lassen sich mit Hilfe der CVD-Diamantsynthese Schmucksteine mit Sichtflächen von z. B. 300 mm und wesentlich größer serienmäßig anfertigen, die auch aufwendige Strukturierungen der Materialschicht, wie z. B. für bildtragende Diamant-Anhänger ermöglichen. Während die Naturdiamanten als Kristall-Individien gefunden werden, lassen sich CVD-Diamantschichten über die Einstellung der Syntheseparameter reproduzieren. Dies hat unter anderem den Vorteil, daß auf der Basis der CVD-Diamantsynthese Serienauflagen von Schmuckstücken angefertigt werden können. Ein weiterer Vorteil der CVD-Diamantsynthese ist die Möglichkeit, die Farbgebung des den Bild- oder Strukturuntergrund bildenden Diamanten über die Syntheseparameter gezielt zu variieren. So können je nach gewünschter Steinqualität für die Strukturgebung verschiedene Kontrasttonstufen wie schwarz, braun, grau oder dgl. angesteuert werden.

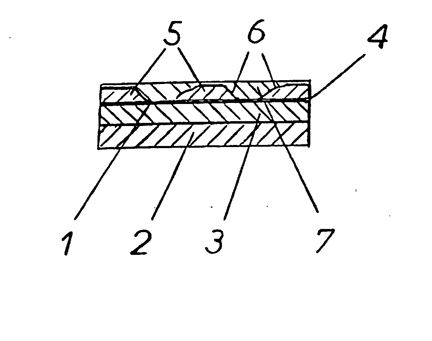

Ein Ausführungsbeispiel der Erfindung wird im folgenden noch an Hand der Zeichnung, die eine schematische Schnittansicht durch einen Schmuckstein zeigt, erläutert:

Das auf die Sichtfläche 1 eines Schmucksteines aufzubringende Bild oder Muster wird mit einem Scanner digitalisiert und in einem Computer abgespeichert. In einem Bildbearbeitungsprogramm werden die Graustufen des gespeicherten Bildes gelöscht, um ein Schwarz-Weiß-Bild zu erhalten, von dem eine Fotomaske erstellt wird.

Auf die Sichtfläche 1 des Schmucksteines, z. B. eine auf einem Siliciumsubstrat 2 abgeschiedene Diamantschicht 3, die entweder auf dem Substrat 2 verbleibt oder durch hohen SP2-Anteil in der Schicht dunkel erscheint, wird ein Haftvermittler 4, z. B. eine Titanoder Chromschicht, aufgebracht, um eine feste Verbindung der niederzuschlagenden Materialschicht, z. B. einer Goldschicht 5 mit dem Diamant zu erhalten. Die Struktur 6 der Goldschicht 5, d. h. zum Darstellen des Bildes, wird in an sich bekannter Weise dadurch erhalten, daß ein Fotolack auf diese Schicht 5 aufgebracht, der Lack ausgebacken und die Fotomaske auf den Lack gebracht sowie der Fotolack durch die Maske belichtet wird. Nach dem Entfernen der nicht belichteten Bereiche des Fotolackes erfolgt die Strukturierung der Goldschicht 5 durch Plasmaätzen in einem Argonplasma. Auf der strukturierten Goldschicht 5 ist noch eine durchsichtige Schutzschicht 7 angebracht.

Die Erfindung ist nicht auf das beschriebene Beispiel begrenzt. Sie schließt für den Fachmann geläufige Abwandlungen ein. So ist jeder natürliche oder künstliche Stein als Träger einer strukturierten Materialschicht für einen erfindungsgemäßen Schmuckstein geeignet, sofern ein ausreichender Kontrast zwischen Stein und Struktur gegeben ist. Es können auch mehrere unterschiedliche Materialschichten auf einer Sichtfläche neben- und/oder übereinander angeordnet sein, wodurch bei entsprechender Strukturierung, insbesondere der übereinander liegenden Materialschichten Hologramme erhalten werden. Die Schmucksteine nach der Erfindung können weiter zur Verzierung von Einrichtungs- und/oder Gebrauchsgegenständen wie Uhren, Vasen oder dgl. dienen oder sogar das Ziffernblatt von Uhren, vorzugsweise Armbanduhren, bilden.

## Patentansprüche

1. Schmuckstein, **dadurch gekennzeichnet, daß** sein Körper (3) aus einem nur für technische oder industrielle Zwecke geeigneten natürlichen oder künstlichen Stein mit mindestens einer Sichtfläche (1) als Träger einer strukturierten Materialschicht (5) besteht.

2. Schmuckstein nach Anspruch 1, **dadurch gekennzeichnet, daß** die Sichtfläche (1) glatt ist.

3. Schmuckstein nach Anspruch 1 oder 2, **dadurch gekennzeichnet, daß** die Materialschicht (5) glänzend ist.

4. Schmuckstein nach einem der Ansprüche 1, 2 oder 3, **dadurch gekennzeichnet, daß** die Materialschicht (5) aus Edelmetall besteht.

5. Schmuckstein nach einem der Ansprüche 1, 2 oder 3, **dadurch gekennzeichnet, daß** die Materialschicht (5) aus Titannitrid besteht.

6. Schmuckstein nach einem der vorhergehenden Ansprüche, **gekennzeichnet durch** eine Metallschicht als Haftvermittler (4) zwischen der Sichtfläche (1) und der Materialschicht (5).

7. Schmuckstein nach Anspruch 6, **dadurch gekennzeichnet, daß** der Haftvermittler (4) eine Titan- oder Chromschicht ist.

8. Schmuckstein nach einem der vorhergehenden Ansprüche, **dadurch gekennzeichnet, daß** sein Körper aus einer nach dem CVD-Verfahren hergestellten Diamantschicht (3) als Träger der Materialschicht (5) besteht.

9. Schmuckstein nach einem der Ansprüche 1 bis 7, **dadurch gekennzeichnet, daß** sein Körper aus einem polykristallinen Diamantaggregat (PKD) als Träger der Materialschicht (5) besteht.

10. Schmuckstein nach einem der vorhergehenden Ansprüche, **dadurch gekennzeichnet, daß** seine Sichtfläche(n) (1) eben, konkav und/oder konvex ist/sind.

11. Schmuckstein nach einem der vorhergehenden Ansprüche, **dadurch gekennzeichnet, daß** auf die Materialschicht (5) eine durchsichtige Schutzschicht (7) aufgebracht ist.

12. Schmuckstein nach Anspruch 11, **dadurch gekennzeichnet, daß** die Schutzschicht (7) eine CVD-Schicht ist und aus Korund oder Diamant besteht.

13. Schmuckstein nach einem der vorhergehenden Ansprüche, **dadurch gekennzeichnet, daß** sein Körper das Ziffernblatt einer Uhr, insbesondere einer Ring-, Armband- oder Schmuckuhr bildet.

## Claims

1. Gemstone, **characterised in that** its body (3) consists of a natural or artificial stone, only suitable for technical or industrial purposes, with at least one visible surface (1) as a carrier of a structured material layer (5).

2. Gemstone according to claim 1, **characterised in that** the visible surface (1) is smooth.

3. Gemstone according to claim 1 or 2, **characterised in that** the material layer (5) is shiny.

4. Gemstone according to any one of claims 1, 2 or 3, **characterised in that** the material layer (5) consists of precious metal.

5. Gemstone according to any one of claims 1, 2 or 3, **characterised in that** the material layer (5) consists of titanium nitride.

6. Gemstone according to any one of the preceding claims, **characterised by** a metal layer as an adhesion promoter (4) between the visible surface (1) and the material layer (5).

7. Gemstone according to claim 6, **characterised in that** the bonding agent (4) is a titanium or chromium layer.

8. Gemstone according to any one of the preceding claims, **characterised in that** its body consists of a diamond layer (3), produced by the CVD method, as a carrier of the material layer (5).

9. Gemstone according to any one of claims 1 to 7, **characterised in that** its body consists of a polycrystalline diamond aggregate as a carrier of the material layer (5).

10. Gemstone according to any one of the preceding claims, **characterised in that** its visible surface(s) (1) is/are flat, concave and/or convex.

11. Gemstone according to any one of the preceding claims, **characterised in that** a transparent protective layer (7) is applied to the material layer (5).

12. Gemstone according to claim 11, **characterised in that** the protective layer (7) is a CVD layer and consists of corundum or diamond.

13. Gemstone according to any one of the preceding claims, **characterised in that** its body forms the face of a clock, in particular of a watch mounted in a ring, a watch or ornamental clock.

## Revendications

1. Pierre ornementale, **caractérisée en ce que** son corps (3) est constitué par une pierre naturelle ou artificielle qui n'est appropriée qu'à une utilisation technique ou industrielle, et qui comporte au moins une face visible (1) servant de support à une couche de matière structurée (5).

2. Pierre ornementale selon la revendication 1, **caractérisée en ce que** la face visible (1) est lisse.

3. Pierre ornementale selon la revendication 1 ou 2, **caractérisée en ce que** la couche de matière (5) est brillante.

4. Pierre ornementale selon la revendication 1, 2 ou 3, **caractérisée en ce que** la couche de matière (5) est en métal précieux.

5. Pierre ornementale selon la revendication 1, 2 ou 3, **caractérisée en ce que** la couche de matière (5) est en nitrure de titane.

6. Pierre ornementale selon l'une des revendications précédentes, **caractérisée par** une couche de métal (4), servant d'agent adhésif, qui est agencée entre la face visible (1) et la couche de matière (5).

7. Pierre ornementale selon la revendication 6, **caractérisée en ce que** l'agent adhésif (4) est une couche de titane ou de chrome.

8. Pierre ornementale selon l'une des revendications précédentes, **caractérisée en ce que** son corps est constitué par une couche de diamant (3) réalisée par le procédé CVD et servant de support à la couche de matière (5).

9. Pierre ornementale selon l'une des revendications 1 à 7, **caractérisée en ce que** son corps est constitué par un agrégat de diamant polycristallin (PKD) servant de support à la couche de matière (5).

10. Pierre ornementale selon l'une des revendications précédentes, **caractérisée en ce que** sa ou ses faces visibles (1) sont planes, concaves et/ou convexes.

11. Pierre ornementale selon l'une des revendications précédentes, **caractérisée en ce qu'**une couche de protection transparente (7) est déposée sur la couche de matière (5).

12. Pierre ornementale selon la revendication 11, **caractérisée en ce que** la couche de protection (7) est une couche CVD qui est constituée par du corindon ou du diamant.

13. Pierre ornementale selon l'une des revendications précédentes, **caractérisée en ce que** son corps forme le cadran d'une montre, en particulier d'une montre montée sur bague, d'une montre-bracelet ou d'une pendule ornementale.
